(19) Europäisches Patentamt
European Patent Office
Office européen des brevets

(11) **EP 1 978 548 B1**

(12) **EUROPEAN PATENT SPECIFICATION**

(45) Date of publication and mention of the grant of the patent:
**11.09.2013 Bulletin 2013/37**

(51) Int Cl.:
*H01L 21/316* *(2006.01)*          *H01L 21/762* *(2006.01)*
*H01L 21/312* *(2006.01)*          *C23C 16/56* *(2006.01)*

(21) Application number: **07713624.0**

(22) Date of filing: **17.01.2007**

(86) International application number:
**PCT/JP2007/050577**

(87) International publication number:
**WO 2007/083654 (26.07.2007 Gazette 2007/30)**

(54) **PROCESS FOR PRODUCING SILICEOUS FILM**

VERFAHREN ZUR HERSTELLUNG EINES SILIZIUMOXIDHALTIGEN FILMS

PROCEDE DE FABRICATION DE FILM SILICEUX

(84) Designated Contracting States:
**DE FR IT NL**

(30) Priority: **18.01.2006   JP 2006010328**

(43) Date of publication of application:
**08.10.2008   Bulletin 2008/41**

(73) Proprietors:
• **AZ Electronic Materials (Japan) K.K.**
**Tokyo 113-0021 (JP)**
• **AZ Electronic Materials USA Corp.**
**Somerville, NJ 08876 (US)**

(72) Inventors:
• **ISHIKAWA, Tomonori**
**Kakegawa-shi,**
**Shizuoka 437-1412 (JP)**
• **NAKAGUMA, Teruno**
**Chiba 2760033 (JP)**

(74) Representative: **Isenbruck, Günter et al**
**Isenbruck Bösl Hörschler LLP**
**Eastsite One**
**Seckenheimer Landstrasse 4**
**68163 Mannheim (DE)**

(56) References cited:
**JP-A- 10 079 382     JP-A- 11 087 332**
**US-A- 5 614 271**

**Description**

TECHNICAL FIELD

This invention relates to a process for producing a siliceous film for use in electronic devices, and a substrate with the siliceous film produced by the process. The present invention also relates to a method for forming a shallow trench isolation structure formed for insulating an electronic device using a polysilazane compound in the production of electronic devices such as semiconductor elements.

Background Art

In general, in electronic devices such as semiconductor devices, semiconductor elements, for example, transistors, resistors and the like are disposed on a substrate. These should be electrically insulated. Accordingly, a region for element isolation should be provided between the elements. This region is called an isolation region. In general, this isolation region has hitherto been provided by selectively forming an insulating film on a surface of a semiconductor substrate.

On the other hand, in the field of electronic devices, increased density and a higher level of integration have recently been forwarded. The progress of an increase in density and an enhancement in level of integration makes it difficult to form a fine isolation structure suitable for a necessary level of integration. This leads to a demand for the development of a novel isolation structure which can meet the need. A trench isolation structure may be mentioned as a structure suitable for meeting the need. In this structure, fine grooves are formed on a surface of a semiconductor substrate, and an insulating material is filled into the grooves to electrically isolate elements formed on both sides of the groove. In the element isolation structure, the isolation region may be narrower than that in the prior art technique, and, thus, the above element isolation structure is useful for realizing a higher level of integration which has recently been demanded.

CVD and high-density plasma CVD may be mentioned as a method for forming the trench isolation structure (see, for example, patent document 1). According to this method, however, when the inside of fine grooves, for example, having a size of not more than 100 nm which has recently been demanded, is filled, in some cases, voids were formed within the grooves. These structure defects are causative of a deterioration in physical strength and insulating properties of the substrate.

On the other hand, in order to improve embedding properties of the trench grooves, studies have been made on a method in which a silicon hydroxide is coated as a solution to form a coating film which is then heat treated to convert silicon hydroxide to silicon dioxide (see, for example, patent document 1). This method, however, is disadvantageous in that, in converting silicon hydroxide to silicon dioxide, volume shrinkage occurs resulting in cracking.

In order to preventing such cracking, studies have been made on a method in which polysilazane is used instead of silicon hydroxide (for example, patent documents 1 and 2). In these methods, an attempt to prevent cracking attributable to volume shrinkage is made by using polysilazane which causes a smaller volume shrinkage upon conversion to silicon dioxide. The method in which a polysilazane-containing composition is coated to fill the grooves followed by treatment in an oxidizing atmosphere to form a high purity and dense silicon dioxide and thus to form a trench isolation structure, is advantageous in that voids are less likely to occur by virtue of excellent permeability of the composition. According to studies conducted by the present inventor, however, it was found that, in this trench isolation structure, in the conversion of polysilazane to silicon dioxide to form a siliceous film, there is a slight difference in reaction conditions between the surface part of the coating film and the inside of the trench, and, thus, the quality of the siliceous film in the inside of the trench is different from the quality of the siliceous film on the outside of the trench, or the quality of the siliceous film varies depending upon the depth within the groove, posing a problem that the etching rate is uneven. This problem is significant when low-temperature treatment, which is required due to a restriction of device design and process design, is carried out. In particular, uneven etching rate is developed as such a phenomenon that the etching rate is higher at a trench part having a high aspect ratio.

Another process for producing a siliceous film, comprising:

an insulating film forming step of forming an insulating film on a surface of a silicon substrate having concavoconvexes;

a coating step of coating a composition containing a polysilazane compound on the substrate; and

a curing step of heating the coated substrate to convert the polysilazane compound to a silicon dioxide film

is disclosed in patent document 4.

Patent document 1 Patent No. 3178412 (paragraphs 0005 to 0016)
Patent document 2 Japanese Patent Laid-Open No. 308090/2001
Patent document 3 Japanese Patent Laid-Open No. 88156/2002
Patent document 4 United States Patent US 5 614 271 A (SHIBUYA TATSUHIKO [JP] ET AL) 25 March 1997 (1997-03-25).

DISCLOSURE OF INVENTION

PROBLEM TO BE SOLVED BY THE INVENTION

In view of the above problems of the prior art, the present invention has been made with a view to providing a process for producing a siliceous film, which can form a siliceous film having a homogeneous quality over its entire part in the formation of a trench isolation structure by forming a siliceous film on a surface of a silicon substrate having concavoconvexes using a polysilazane compound, or in the covering of the surface with a homogeneous siliceous film, and an electronic device comprising a siliceous film formed by the process.

MEANS FOR SOLVING PROBLEM

According to the present invention, there is provided a process for producing a siliceous film, comprising:

an insulating film forming step of forming an insulating film having a hydrogen content of not less than $9 \times 10^{20}$ atms/cm$^3$ as measured by a secondary ion mass spectrometry on a surface of a silicon substrate having concavo-convexes;
a coating step of coating a composition containing a polysilazane compound on the substrate; and
a curing step of heating the coated substrate to convert the polysilazane compound to a silicon dioxide film.

EFFECT OF THE INVENTION

The production process of a siliceous film according to the present invention can produce a substrate with a siliceous film which, upon heat treatment at a relatively low temperature, is homogeneous in the quality of the siliceous film independently of whether concavoconvexes are present on the substrate, and in both the inside and outside of the grooves, particularly independently of the depth of the groove part, and can realize an even etching rate in the etching treatment. At the same time, this siliceous film is free from voids and cracks within the grooves. That is, this siliceous film, when used in a semiconductor element, causes no deterioration in properties and has excellent mechanical strength. Further, in the siliceous film, the heat treatment can be carried out at a relatively low temperature, and, thus, the siliceous film is also suitable for the production of electronic devices in recent years involving a problem of high temperature treatment, for example, which adversely affects device properties due to oxidation or a change in crystal structure of a silicon substrate.

BRIEF DESCRIPTION OF THE DRAWINGS

[Fig. 1] Fig. 1 is a cross-sectional view of a trench isolation structure produced according to the present invention.
[Fig. 2] Fig. 2 is a cross-sectional view illustrating a trench isolation structure in a working example (before etching).
[Fig. 3] Fig. 3 is a cross-sectional view illustrating a trench isolation structure in a working example (after etching).
[Fig. 4] Fig. 4 is a cross-sectional view illustrating a trench isolation structure in a working example (after etching).

DESCRIPTION OF REFERENCE CHARACTERS

1: silicon substrate
2: silicon nitride film
3: insulating film
4: polysilazane coating film
5: substrate with grooves including insulating film
6: siliceous film

BEST MODE FOR CARRYING OUT THE INVENTION

Production process of siliceous film

The production process of a siliceous film according to the present invention can form a film, which is free from voids and has a homogenous film quality, on a silicon substrate having concavoconvexes. Accordingly, the siliceous film can be formed as a flattening insulating film (a premetal insulating film) for a transistor part or a capacitor part in an electronic device. Alternatively, the siliceous film may be formed on a grooved silicon substrate to fill the grooves and thus to form a trench isolation structure. The present invention will now be described based on a method for forming a trench isolation structure.

In the production process of a siliceous film according to the present invention, treatment is carried out according to the following procedure to form a trench isolation structure:

an insulating film forming step of forming an insulating film having a hydrogen content of not less than $9 \times 10^{20}$ atms/cm$^3$ as measured by a secondary ion mass spectrometry (hereinafter referred to as "SIMS analysis") on a surface of a silicon substrate having concavoconvexes;
a coating step of coating a composition containing a polysilazane compound on the substrate; and
a curing step of heating the coated substrate to convert the polysilazane compound to a silicon dioxide film.

(A) Insulating film forming step

In the process according to the present invention, prior to the insulating film forming step, a silicon substrate having concavoconvexes is provided. In particular, when a trench isolation structure is formed, a silicon substrate having a desired groove pattern is provided. In the formation of the grooves, any desired method may be used, and examples thereof are also described in patent document 1 or 2. More specific methods are as follows.

A silicon dioxide film is first formed, for example, by a thermal oxidation method, on a surface of a silicon substrate. The thickness of the silicon dioxide film is generally 5 to 30 nm.

If necessary, a silicon nitride film is formed, for example, by a low pressure CVD method, on the formed silicon dioxide film. This silicon nitride film can function as a mask in an etching step which will be described later, or as a stop layer in a polishing step which will be described later. The thickness of the silicon nitride film is generally 100 to 400 nm.

A photoresist is coated onto the silicon dioxide film or silicon nitride film thus formed. If necessary, after the photoresist film is dried or cured, the photoresist film is exposed in a desired pattern and is developed to form a pattern. The exposure may be carried out by any desired method such as mask exposure or scanning exposure. The photoresist may also be any desired one, for example, from the viewpoint of resolution.

A silicon nitride film and a silicon dioxide film underlying the silicon nitride film are successively etched using the formed photoresist film as a mask. According to this procedure, a desired pattern is formed in the silicon nitride film and the silicon dioxide film.

The silicon substrate is dry etched by using the patterned silicon nitride film and silicon dioxide film as a mask to form a trench isolation groove.

The width of the trench isolation groove is determined by a pattern in which the photoresist film is exposed. The trench isolation groove in the semiconductor element generally has a width of 0.02 to 10 $\mu$m, preferably 0.05 to 5 $\mu$m, and a depth of 200 to 1000 nm, preferably 300 to 700 nm, although the width and depth may vary depending upon the contemplated semiconductor element. As compared with the conventional method for forming a trench isolation structure, the method according to the present invention can realize uniform embedding in a narrower manner to a deeper part and thus is suitable for the formation of a narrower and deeper trench isolation structure.

An insulating film is further formed on the substrate surface with grooves formed therein. The insulating film continuously covers the substrate surface including the inside of the grooves. In the present invention, the content of hydrogen in the insulating film as measured by SIMS analysis is not less than $9 \times 10^{20}$ atms/cm$^3$, preferably not less than $1 \times 10^{21}$ atms/cm$^3$. When the hydrogen content is below the lower limit of the above-defined range, as described below, hydrogen does not migrate into the polysilazane coating film and, consequently, the effect of the present invention cannot be attained. The insulating film having a high hydrogen content can be formed by any desired method but is preferably formed by plasma chemical vapor deposition. In particular, a silicon dioxide film formed by plasma chemical vapor deposition using an organosilane compound such as tetraethoxysilane (hereinafter referred to as "TEOS") and a silicon nitride film formed by plasma chemical vapor deposition are preferred. In particular, the insulating film formed by the plasma chemical vapor deposition contains a nonstoichiometric, i.e., excessive amount of hydrogen, and, thus, the hydrogen content is not brought to zero. On the other hand, the insulating film formed, for example, by coating a silicon-containing composition or the like in an aqueous solution form and heating the coating has a very low hydrogen content due to high-temperature treatment, and, thus, in this method, it is difficult to provide an insulating film having a hydrogen content specified in the present invention. When the insulating film in the present invention has a hydrogen content in the above-defined range, the effect of the present invention can be attained and, thus, the method for insulating film formation is not particularly limited. Even when an insulating film having a satisfactorily high hydrogen content is formed, the release of hydrogen before curing after the formation of a polysilazane coating film on the insulating film makes it impossible to attain the effect of the present invention. Details thereof will be described later. For example, when a silicon dioxide film formed by plasma chemical vapor deposition using TEOS is annealed at an elevated temperature, hydrogen is in many cases disadvantageously released from the insulating film. Accordingly, the heat treatment of the insulating film before the formation of the polysilazane coating film is unfavorable. When the annealing treatment is necessary, the upper limit of the annealing temperature is generally 100°C above the temperature at which the insulating film is formed.

The SIMS analysis for measuring the content of hydrogen in the insulating film are carried out under the following conditions.

Measuring device: 6600 manufactured by Physical Electronics, Inc.
Primary ion species: Cs
Primary acceleration voltage: 5.0 kV
Detection region: 120 $\mu$m $\times$ 192 $\mu$m

The insulating film may have any desired thickness so far as the effect of the present invention is not sacrificed. In general, the thickness of the insulating film is 1 to 100 nm, preferably 2 to 20 nm.

(B) Coating step

A coating film of a composition containing a polysilazane compound, which is a material for a siliceous film, is then formed on a silicon substrate in which grooves have been formed in the insulating film in the above insulating film forming step.

The polysilazane compound usable in the method according to the present invention is not particularly limited, and polysilazane compounds described in the above-described patent document 1 or 2 may be used. One example of a process for producing a polysilazane composition usable in the present invention will be described.

Dichlorosilane having a purity of not less than 99% is introduced with stirring into dehydrated pyridine regulated to a range of -20 to 20°C.

Subsequently, the temperature is regulated to- 20 to 20°C, and ammonia having a purity of not less than 99% is introduced with stirring into the system. Here a crude polysilazane and ammonium chloride as a by- product are produced in the reaction solution.

The ammonium chloride produced by the reaction is removed by filtration.

The filtrate is heated to 30 to 150°C, and, while removing the residual ammonia, the molecular weight of the polysilazane is regulated to a weight average molecular weight of 1500 to 15000.

The organic solvent is heated to 30 to 50°C, and vacuum distillation is carried out at a pressure of not more than 50 mmHg to remove the residual pyridine. Organic solvents usable herein include (i) aromatic compounds, for example, benzene, toluene, xylene, ethylbenzene, diethylbenzene, trimethylbenzene, triethylbenzene, and decahydronaphthalene, (ii) chain saturated hydrocarbons, for example, n- pentane, i- pentane, n- hexane, i- hexane, n- heptane, i- heptane, n- octane, i- octane, n- nonane, i- nonane, n- decane, and i- decane, (iii) cyclic saturated hydrocarbons, for example, cyclohexane, ethylcyclohexane, methylcyclohexane, and p- menthane, (iv) cyclic unsaturated hydrocarbons, for example, cyclohexene and dipentene (limonene) , (v) ethers, for example, dipropyl ether, dibutyl ether, and anisole, (vi) esters, for example, n- butyl acetate, i- butyl acetate, n- amyl acetate, and i- amyl acetate, and (vii) ketones, for example, methyl i- butyl ketone.

Pyridine is removed by the vacuum distillation, and, at the same time, the organic solvent is removed to regulate the polysilazane concentration to a range of generally 5 to 30% by weight.

The polysiazane composition is circulated and filtered through a filter with a pore size of not more than 0.1 $\mu$m to reduce the number of coarse particles having a particle diameter of not less than 0.2 $\mu$m to not more than 50/cc.

The above process for producing a polysilazane composition is one of production processes usable in the present invention, and the production process is not limited to this production process only. A method may also be adopted in which a solid polysilazane is obtained and, in use, is dissolved or dispersed in the above proper solvent to a concentration of generally 5 to 30% by weight. The concentration of the solution should be properly regulated depending, for example, upon the thickness of the polysilazane coating film to be finally formed.

The provided polysilazane composition may be coated onto a substrate by any desired method, and specific examples of such methods include spin coating, curtain coating, dip coating, and other coating methods. Among them, spin coating is particularly preferred, for example, from the viewpoint of providing a homogeneous coating film face.

The thickness of the polysilazane coating film is generally 10 to 1000 nm, preferably 50 to 800 nm, from the viewpoint of simultaneously realizing trench groove embedding properties and flatness of the polysilazane coating film surface after coating of the polysilazane composition.

The conditions for coating may vary depending, for example, upon the concentration of the polysilazane composition, solvent or coating method. Conditions for spin coating will be described as an example of coating conditions as follows.

In recent years, in order to improve production yield, in many cases, elements are formed on a large substrate. When the formation of a homogeneous polysilazane coating film on a silicon substrate having a size of not less than 8 inches is contemplated, spin coating using a combination of a plurality of steps is effective.

A polysilazane composition is dropped on the central part of the silicon substrate or on a few places including the central part so as to form a uniform coating film over the whole surface of the substrate in an amount of generally 0.5 to 20 cc per sheet of silicon substrate.

The substrate is then spun at a relatively low spinning speed for a short period of time, for example, at a spinning speed of 50 to 500 rpm for 0.5 to 10 sec, to spread the dropped polysilazane solution over the whole surface of the silicon substrate (prespinning).

The substrate is then spun at a relatively high spinning speed, for example, at a spinning speed of 500 to 4500 rpm for 0.5 to 800 sec, to bring the coating film to a desired thickness (main spinning).

The substrate is further spun at a spinning speed which is higher by at least 500 rpm than the main spinning speed, for example, at a spinning speed of 1000 to 5000 rpm, for 5 to 300 sec to reduce protuberance of the polysilazane coating film around the silicon substrate and to remove the solvent in the polysilazane coating film by drying as much as possible (final spinning).

These coating conditions may be properly regulated depending, for example, upon the size of the substrate used and the contemplated properties of the semiconductor element.

(C) Curing step

After the coating of the polysilazane composition, if necessary, the coated substrate is subjected to a prebaking step (which will be described later), and the whole substrate is then heated to convert the polysilazane coating film to a siliceous film and thus to cure the coating. It is common practice to heat the whole substrate, for example, in a curing oven.

The curing is preferably carried out using a curing oven or a hot plate in a water vapor-containing inert gas or oxygen atmosphere. The water vapor is important for satisfactorily converting the polysilazane to a siliceous film (that is, silicon dioxide). The concentration of the water vapor is preferably not less than 30%, more preferably not less than 50%, still more preferably not less than 70%. In particular, a water vapor concentration of not less than 80% is advantageous in that the conversion of the polysilazane to the siliceous film easily proceeds and defects such as voids are reduced resulting in improved properties of the siliceous film. When the atmosphere gas is an inert gas, for example, nitrogen, argon or helium is usable.

The temperature for curing varies depending upon the type of the polysilazane compound used and a combination of steps (which will be described later). However, there is a tendency that the speed of conversion of the polysilazane compound to the siliceous film is increased with raising the temperature. Further, there is a tendency that the adverse effect on device properties by oxidation of the silicon substrate or a change in crystal structure reduces with decreasing the temperature. From the above viewpoints, in the method according to the present invention, heating is carried out in one step at a temperature of 400°C to 1200°C, preferably 500°C to 1000°C. In the present invention, by virtue of the presence of the insulating film which can release hydrogen, the coating can be satisfactorily cured by heat treatment at a relatively low temperature. From the viewpoint of the influence on device properties, curing at a lower temperature is preferred. In this case, the temperature is raised to a target temperature at a temperature rise rate of generally 1 to 100°C/min, and the curing time after the arrival of the temperature at the target temperature is generally 1 min to 10 hr, preferably 15 min to 3 hr. If necessary, the curing temperature or the composition of the curing atmosphere can also be changed stepwise. In the present invention, by virtue of the presence of the insulating film which can release hydrogen, satisfactory curing can be realized by heat treatment at a relatively low temperature. Curing at a lower temperature is preferred from the viewpoint of the influence on device properties.

Upon heating, the polysilazane compound is converted to silicon dioxide which constitutes a siliceous film. In the process according to the present invention, it has been found that hydrogen migrates from the hydrogen-containing insulating film to the polysilazane coating film. It is considered that, upon the migration of hydrogen into the polysilazane coating film, the reaction which converts the polysilazane compound to silicon dioxide is rendered homogeneous. Accordingly, when an insulating film having a hydrogen content of zero or substantially zero is used, the effect of the present invention cannot be attained.

The method for forming a trench isolation structure according to the present invention should comprise the above steps (A) to (C). If necessary, additional steps may be provided in combination with the above steps. Steps which may be provided in combination with the steps (A) to (C) will be described.

(a) Prebaking step

Prior to the curing step, the substrate coated with the polysilazane solution may be prebaked. This step is provided to fully remove the solvent contained in the polysilazane coating film and to precure the polysilazane coating film. In particular, in the method for forming a trench isolation structure using polysilazane according to the present invention, prebaking treatment can improve the denseness of the siliceous film, and, thus, the prebaking step is preferably additionally provided in combination with the above steps.

In the conventional prebaking step, a method has been adopted in which heating is carried out at a substantially constant temperature. In this method, the coating film shrinks upon curing, and, disadvantageously, the groove part in the trench isolation structure is recessed, or voids occur within the grooves.

In the method according to the present invention, when prebaking treatment is carried out, preferably, the temperature in the prebaking step is regulated, and prebaking is carried out while raising the temperature over time. In this case, the temperature in the prebaking step is generally 50°C to 400°C, preferably 100°C to 300°C. The time necessary for the prebaking step is generally 10 sec to 30 min, preferably 30 sec to 10 min.

Methods for raising the temperature in the prebaking step over time include a method in which the temperature of an atmosphere in which the substrate is placed, is raised stepwise or a method in which the temperature is raised monotonously. The highest prebaking temperature in the prebaking step is generally above the boiling point of the solvent used in the polysilazane solution from the viewpoint of removing the solvent from the film.

In the method in which the temperature in the prebaking step is raised stepwise, for example, the procedure consisting of holding the temperature of the substrate at a specific given temperature for a given period of time and then holding the substrate at a given temperature above the specific given temperature for a given period of time, for example, the procedure consisting of holding the substrate at temperature T1 for a few minutes and then holding the substrate at temperature T2, which is a temperature above the temperature T1, for a few minutes, is repeated. The difference in temperature between the temperature holding stages is generally 30 to 150°C, and the time for which the substrate is held at the given temperature is generally 10 sec to 3 min for each temperature. Prebaking under such conditions can realize significant development of the effect of the present invention.

For example, when prebaking is carried out at two stage temperatures, the first-stage prebaking temperature is preferably in the range of (1/4) A to (3/4) A (°C) wherein A (°C) is the second-stage prebaking temperature (highest prebaking temperature).

For example, when prebaking is carried out at three stage temperatures, the first-stage prebaking temperature and the second-stage prebaking temperature are preferably in the range of (1/4) A to (5/8) A (°C) and in the range of (5/8) A to (7/8) A (°C), respectively, wherein A(°C) is the third-stage prebaking temperature (highest prebaking temperature).

For example, when a solvent having a boiling point of about 150°C such as xylene is used in the polysilazane solution and, further, the highest prebaking temperature is 200°C, (a) in the case where prebaking is carried out at two stage temperatures, the first-stage prebaking temperature is preferably 50 to 150°C, and (b) in the case where prebaking is carried out at three stage temperatures, preferably, the first-stage prebaking temperature is 50 to 125°C and the second-stage prebaking temperature is 125 to 175°C.

Specifically, also in the method in which the temperature is raised stepwise, temperature setting at a plurality of stages is carried out so that, as the whole prebaking step, the temperature is gently raised and reaches the target temperature.

In the method in which the temperature is raised monotonously, the temperature should be at least 0°C above a point of time before that point. The difference between the temperature of a point of time and the temperature of any point of time before that point of time may be zero but should not be negative. In other words, when the prebaking temperature is plotted against the time, the gradient of the temperature curve should not be negative. Here the substrate temperature is raised so that the heating rate is generally 0 to 500°C/min, preferably 10 to 300°C /min. The higher the heating rate, the higher the degree of shortening of the process time. From the viewpoints of removing the solvent present within the groove structure and satisfactorily polymerizing polysilazane, the heating rate is preferably low.

In the present invention, the expression "the temperature is regulated so that the temperature in the prebaking step is raised over time" excludes, for example, the case where, a low-temperature substrate is transferred to high-temperature conditions and the temperature is rapidly raised to render the temperature of the substrate identical to the temperature of the atmosphere followed by prebaking of the substrate while maintaining the temperature. In this case, the temperature of the substrate is raised over time, but the temperature rise, however, is not regulated. In the above case, the effect of the present invention cannot be in many cases attained.

The purpose of regulating the temperature in the prebaking step is to prevent a rapid temperature rise in the coating film in the prebaking step and thus to raise the temperature of the substrate at a lower temperature rise rate than that in prebaking by commonly adopted one-stage heating. The reason why, for example, voids within the grooves are reduced by the method according to the present invention has not been elucidated yet, but is believed to reside in that, upon a rapid rise in temperature of the substrate, the surface of the substrate is disadvantageously excessively cured before the complete removal of the solvent from within the trench isolation grooves and the vapor of the solvent remains within the grooves. The present invention solves the above problem by regulating the temperature in the prebaking step.

In the method according to the present invention, when the prebaking step is provided in combination with the above steps, the substrate of which the temperature has been raised to an elevated temperature by prebaking, is preferably subjected to a curing step before the temperature of the substrate is lowered, preferably at a substrate temperature of 50°C or above and the highest prebaking temperature or below. When the substrate is subjected to the curing step before the temperature of the substrate is lowered, the energy and time necessary for raising the temperature again can be saved.

(b) Polishing step

After curing, preferably, the unnecessary part of the cured silicon dioxide film is removed. To this end, the polysilazane coating film present on the substrate surface is first removed by polishing. This step is a polishing step. The polishing step may be carried out after the curing treatment. Alternatively, when the prebaking step is additionally provided in combination with the above steps, the polishing step may be carried out immediately after prebaking.

The polishing is carried out by chemical mechanical polishing (hereinafter referred to as "CMP"). The polishing by CMP may be carried out by conventional polishing agent and polishing apparatus. Specifically, a commercially available common CMP apparatus may be used as a polishing apparatus which can use, for example, an aqueous solution containing an abrasive such as silica, alumina or ceria, and optionally other additives dispersed therein.

(c) Etching step

In the above polishing step, most of the polysilazane-derived siliceous film present on the substrate surface is removed. In order to remove the remaining siliceous film, further etching treatment is preferably carried out. An etching liquid is generally used in the etching treatment. The etching liquid is not particularly limited so far as the siliceous film can be removed. In general, an aqueous hydrofluoric acid solution containing ammonium fluoride. The concentration of ammonium fluoride in the aqueous solution is preferably not less than 5%, more preferably not less than 30%.

In the trench isolation structure formed by the conventional method, in some cases, the quality of the siliceous film within the grooves is different from the quality of the siliceous film present outside the grooves. Due to this drawback, in some cases, upon the treatment of the substrate by the polishing or etching, for example, the groove part is recessed resulting in a deterioration in quality of the final product. By contrast, in the trench isolation structure formed by the method according to the present invention, the quality of the film is homogeneous, and, thus, the production of products having desired properties is possible.

Substrate with siliceous film which is not part of the invention

The substrate with a siliceous film according to the present invention has been produced by a production process of a siliceous film described above in connection with the method for trench isolation structure formation as an example. In this substrate with a siliceous film, since the quality of the siliceous film is homogeneous over the whole siliceous film, the mechanical strength is also homogeneous. Further, even when etching or polishing is carried out, the homogeneity and flatness can be maintained and, consequently, excellent final products can be provided.

Example 1

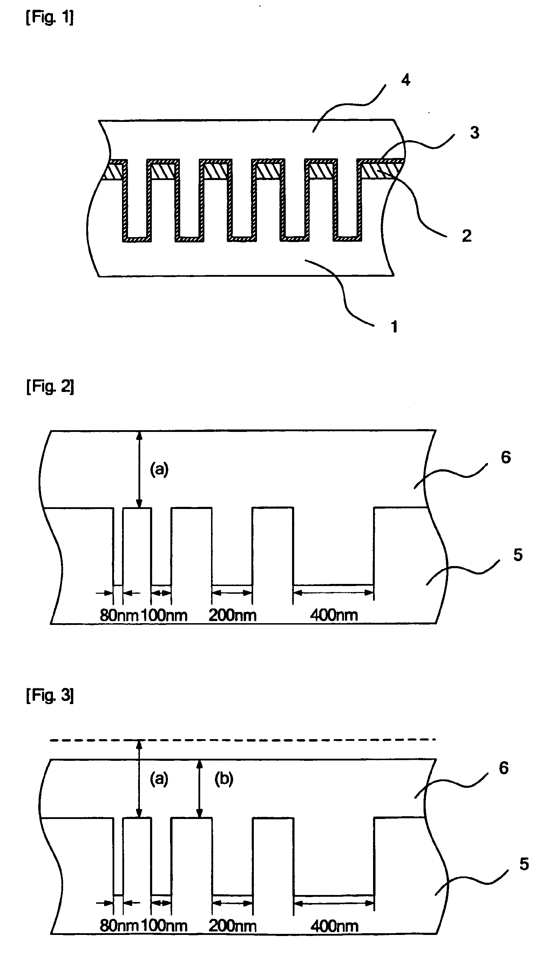

The present invention will be further described with reference to the following Example which illustrate a contemplated technique for embedding element isolation grooves of STI (shallow trench isolation) structures in conjunction with Fig. 1.

A grooved sample for the evaluation of a construction as shown in Fig. 1 was first provided. This grooved sample has been formed by depositing a silicon nitride (SiN) film 2 on an upper surface of a silicon substrate 1, for example, to a thickness of 150 nm and then forming grooves by lithography and dry etching (five grooves are shown in the drawing). In this case, for all the five grooves, the width was, for example, 80 nm to 400 nm, and the depth was, for example, 450 nm (the depth of the silicon substrate part was 300 nm).

A 20 nm-thick silicon dioxide film 3 was deposited on the grooved sample having the above construction by plasma chemical vapor deposition (plasma TEOS) using TEOS as a silicon source.

The silicon dioxide film 3 was formed using the above plasma TEOS technique under the following film forming conditions. TEOS/$O_2$ gas flow rate and source power/bias power: TEOS/$O_2$ = 55/110 sccm, SRF/BRF = 4400/2600 W, and substrate temperature = 350°C.

SIMS analysis and TDS measurement have revealed that the plasma TEOS film contained an excessive amount of hydrogen. Specifically, according to the SIMS analysis, the content of hydrogen in the film was about $2 \times 10^{21}$ atms/$cm^3$, and, according to the TDS analysis, it was confirmed that hydrogen was released from the film in vacuo at a temperature around 350°C, indicating that this film contained hydrogen.

A polysilazane solution was then prepared. A gas introduction tube, a mechanical stirrer, and a Dewar condenser were mounted on a four-necked flask having an internal volume of 2 liters as a reaction vessel. The atmosphere in the reaction vessel was replaced with dry nitrogen. Dry pyridine (1500 ml) was then placed in the four-necked flask, and the flask was kept at 20°C on an oil bath. Upon subsequent addition of dichlorosilane (100 g), a white solid adduct ($SiH_2Cl_2 \cdot 2C_5H_5N$) was produced. The reaction mixture was cooled with ice, and 70 g of ammonia was gradually blown into the reaction mixture with stirring. Subsequently, dry nitrogen was blown into the liquid phase for 30 min to remove excess ammonia. The product thus obtained filtered under reduced pressure in a dry nitrogen atmosphere through a Buchner funnel to give 1200 ml of a filtrate. Pyridine was removed by evaporation with an evaporator to give 45 g of perhydropolysilazane.

This perhydropolysilazane was dissolved in dibutyl ether, dried thoroughly over a molecular sieve, to give a solution having a concentration of 20%. The solution was then filtered through a PTFE filter, pore size of 50-nm, to give a polysilazane solution.

The polysilazane solution thus obtained was spin coated to form a polysilazane coating film 4. The spin coating was carried out at a main spin speed of 2000 rpm/30 sec.

The polysilazane coating film 4 thus formed was placed in a water vapor-containing oxidizing atmosphere for heat treatment. Specifically, the polysilazane coating film 4 was heat treated in an $H_2O$ atmosphere ($H_2O$ concentration: 50%, carrier gas: oxygen) of 400°C for 30 min and was then heat treated in an $N_2$ atmosphere of 700°C for 30 min. The heat treatment was carried out in an oxidizing furnace VF-1000 manufactured by KOYO THERMO SYSTEMS CO., LTD. Thus, a sample having a construction as shown in Fig. 1 was formed.

Example 2

A sample was prepared in the same manner as in Example 1, except that a 20 nm-thick silicon nitride film was deposited instead of the plasma TEOS film shown in Fig. 1 by plasma chemical vapor deposition (PE-CVD). The silicon nitride film 3 was formed by the above PE-CVD under the following film forming conditions. $SiH_4$/$NH_3$ gas flow rate and source power/bias power: $SiH_4$/$NH_3$ = 55/110 sccm, SRF/BRF = 4400/2600 W, and substrate temperature = 400°C.

SIMS analysis and TDS measurement have revealed that the plasma PE-CVD film contained an excessive amount of hydrogen. Specifically, according to the SIMS analysis, the content of hydrogen in the film was about $1 \times 10^{21}$ atms/$cm^3$, and, according to the TDS analysis, it was confirmed that hydrogen was released from the film in vacuo at a temperature around 350°C, indicating that this film contained hydrogen.

The film formation using the polysilazane solution and the heat treatment were carried out in the same manner as in Example 1.

Comparative Example 1

A sample was prepared in the same manner as in Example 1, except that a 20 nm-thick silicon nitride film was deposited instead of the plasma TEOS film shown in Fig. 1 by low-pressure CVD (LP-CVD silicon nitride film).

The silicon nitride film 3 (insulating film) was formed using the above LP-CVD technique under the following film forming conditions. $SiH_4$/$NH_3$ gas flow rate: $SiH_4$/$NH_3$ = 55/110 sccm and substrate temperature = 700°C.

The LP-CVD silicon nitride film was found to have a good quality and to have a low hydrogen content by subjecting the solid plasma TEOS film to an SIMS analysis and a TDS analysis. The SIMS analysis revealed that the content of hydrogen in the film was about $1 \times 10^{20}$ atms/$cm^3$, and the TDS analysis revealed that, except for the release of adsorbed water, gas release was not observed even in vacuo at a temperature up to 700°C, indicating that the film did not contain any releasable hydrogen.

The film formation using the polysilazane solution and the heat treatment were carried out under the same conditions as in Example 1.

Comparative Example 2

A 20 nm-thick silicon dioxide film 3 was deposited by plasma TEOS in the same manner as in Example 1. The sample thus obtained was once annealed in a nitrogen atmosphere at 700°C. The annealed plasma TEOS film was found to have a low hydrogen content by subjecting the solid plasma TEOS film to an SIMS analysis and a TDS analysis. The SIMS analysis revealed that the content of hydrogen in the film was about $8 \times 10^{20}$ atms/cm$^3$, and the TDS analysis revealed that, except for the release of adsorbed water, gas release was not observed even in vacuo at a temperature up to 700°C, indicating that the film did not contain any releasable hydrogen.

It is considered that a large amount of hydrogen contained in the film during plasma TEOS film formation was released by the annealing treatment. The film formation using the polysilazane solution and the heat treatment were carried out under the same conditions as in Example 1.

Thereafter, for the above four samples, the refractive index was measured, and the results were as summarized below.

| | |
|---|---|
| Example 1 | 1.447 |
| Example 2 | 1.448 |
| Comparative Example 1 | 1.445 |
| Reference Example 1 | 1.444 |

The above results show that, for all the samples, the polysilazane coating film 4 was a silicon dioxide film.

Example 3

A sample was prepared in the same manner as in Example 1, except that a 20 nm-thick silicon dioxide film was deposited instead of the plasma TEOS film shown in Example 1 by plasma chemical vapor deposition using SiH$_4$ and O$_2$ as a source.

The silicon dioxide film 3 was formed under the following film forming conditions. SiH$_4$/O$_2$ gas flow rate and source power/bias power: SiH$_4$/O$_2$ = 50/100 sccm, SRF/BRF = 4500/3000 W, and substrate temperature = 250°C.

SIMS analysis and TDS measurement have revealed that the silicon dioxide film contained an excessive amount of hydrogen. Specifically, according to the SIMS analysis, the content of hydrogen in the film was about $1.5 \times 10^{21}$ atms/cm$^3$.

The film formation using the polysilazane solution and the heat treatment were carried out in the same manner as in Example 1.

Example 4

A sample was prepared in the same manner as in Example 1, except that a 20 nm-thick silicon dioxide film was deposited instead of the plasma TEOS film shown in Fig. 1 by low-pressure chemical vapor deposition using SiH$_4$ and O$_2$ as a source.

The silicon dioxide film 3 was formed under the following film forming conditions. SiH$_4$/O$_2$ gas flow rate: SiH$_4$/O$_2$ = 50/100 sccm, substrate temperature = 700°C, and pressure = 1 Torr.

SIMS analysis and TDS measurement have revealed that the silicon dioxide film contained an excessive amount of hydrogen. Specifically, according to the SIMS analysis, the content of hydrogen in the film was about $1.1 \times 10^{21}$ atms/cm$^3$.

The film formation using the polysilazane solution and the heat treatment were carried out in the same manner as in Example 1.

Example 5

A sample was prepared in the same manner as in Example 1, except that a 20 nm-thick silicon dioxide film was deposited instead of the plasma TEOS film shown in Example 1 by low-pressure chemical vapor deposition using TEOS and O$_2$ as a source.

The silicon dioxide film 3 was formed under the following film forming conditions. TEOS/O$_2$ gas flow rate: TEOS/O$_2$ = 50/100 sccm, substrate temperature = 700°C, and pressure = 1 Torr.

SIMS analysis and TDS measurement have revealed that the silicon dioxide film contained an excessive amount of hydrogen. Specifically, according to the SIMS analysis, the content of hydrogen in the film was about $1.2 \times 10^{21}$ atms/cm$^3$.

The film formation using the polysilazane solution and the heat treatment were carried out in the same manner as in Example 1.

Example 6

A sample was prepared in the same manner as in Example 1, except that a 20 nm-thick silicon dioxide film was deposited instead of the plasma TEOS film shown in Example 1 by rapid thermal deposition using $SiH_4$ and $N_2O$ as a source.

The silicon dioxide film 3 was formed under the following film forming conditions. $SiH_4/N_2O$ gas flow rate: $SiH_4/N_2O$ = 10/250 sccm, and substrate temperature = 800°C.

SIMS analysis and TDS measurement have revealed that the silicon dioxide film contained an excessive amount of hydrogen. Specifically, according to the SIMS analysis, the content of hydrogen in the film was about $1.2 \times 10^{21}$ atms/cm$^3$.

The film formation using the polysilazane solution and the heat treatment were carried out in the same manner as in Example 1.

(Measurement of film quality in deep part of trench)

At the outset, a substrate was cut in a direction perpendicular to the longitudinal direction of the grooves, and the groove part in the cross section was observed from a direction perpendicular to the cross section at a magnification of 100,000 times under SEM (model S-4600, manufactured by Hitachi, Ltd.) to measure the length (a) from the grooved substrate 5 including an insulating film to the surface of the siliceous film 6 as shown in Fig. 2 (before etching).

Next, the substrate cut in a direction perpendicular to the longitudinal direction of the grooves was immersed in an aqueous solution containing 0.5% by weight of hydrofluoric acid and 5% by weight of ammonium fluoride at 20°C for one min, was thoroughly washed with pure water, and was dried. The groove part in the cross section was first observed under the above SEM at a magnification of 100, 000 times from a direction perpendicular to the cross section to measure the length (b) shown in Fig. 3 (after etching 1) , that is, the thickness from the grooved substrate 5 including an insulating film to the surface of the siliceous film 6.

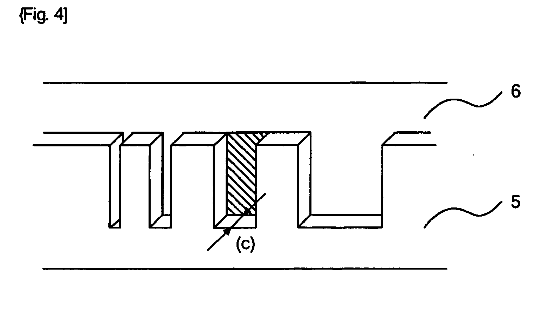

Subsequently, likewise, in the groove part in the cross section, the deepest part of the groove was observed under the above SEM at a magnification of 200, 000 times in a direction perpendicular to the cross section from above the sample at an angle of elevation of 30 degrees and was photographed, and the etching length (c) was calculated by trigonometry from the length on the photograph. See Fig. 4 (after etching 2) .

The etching length (c) in the deepest part of the grooves varies depending upon the width of the grooves (aspect ratio). Accordingly, the etching length (c) was measured for grooves with four widths (80 nm, 100 nm, 200 nm, and 400 nm). The etching rate (A) regarding the inside of the fine grooves and the etching rate (B) regarding the outside of the grooves were determined by calculation using the obtained data (a), (b), and (c) as follows.

$$(A) = (c)$$

$$(B) = (a) - (b)$$

Regarding the state of interface after etching, whether or not the inside of the groove and an oblique line part shown in Fig. 4 (after etching 2) are smooth was evaluated using an SEM photograph. Since the state of etching interface varies depending upon the width of the groove (aspect ratio), the state of interface was evaluated for each of grooves with four widths (80 nm, 100 nm, 200 nm, and 400 nm).

The results of measurement obtained by the above method were as shown in Table 1.

Further, for the samples of Examples 1 and 2 and Comparative Examples 1 and 2, the element profile in the depth- wise direction was again examined by SIMS after polysilazane film formation and heat treatment. As a result, it was confirmed that, in Examples 1 and 2 (containing an excessive amount of hydrogen) , hydrogen migrated from the insulating film 3 to the polysilazane coating film 4. For example, for the sample of Example 1, the hydrogen content was changed from $2 \times 10^{21}$ atms/cm$^3$ to $6 \times 10^{20}$ atms/cm$^3$. It was also found that nitrogen migrated from the polysilazane coating film 4 to the insulating film 3 (containing an excessive amount of hydrogen) . For example, the nitrogen content was changed from $1 \times 10^{18}$ atms/cm$^3$ to $1 \times 10^{20}$ atms/cm$^3$.

On the other hand, in Comparative Examples 1 and 2, neither hydrogen nor nitrogen migrated. Further, the distribution of etching properties in the depth-wise direction is large. Accordingly, it is considered that the release and migration of excess hydrogen from the P-TEOS or PE-CVD silicon nitride film, and/or the release and migration of nitrogen from the polysilazane to the P-TEOS or PE-CVD silicon nitride film during the heat treatment of the polysilazane are useful for the conversion of the polysilazane coating film 4 to a homogeneous oxide film.

[Table 1]

Table 1-1: Evaluation of etching rate

| | B (Å/min) | A/B | | | |
|---|---|---|---|---|---|
| | | 80nm | 100nm | 200nm | 400nm |
| Example 1 | 210 | 1.2 | 1.2 | 1.2 | 1.1 |
| Example 2 | 220 | 1.4 | 1.3 | 1.3 | 1.2 |
| Comp.Ex. 1 | 220 | 9.0 | 6.5 | 5.0 | 4.0 |
| Comp.Ex. 2 | 210 | 10.0 | 8.0 | 6.0 | 6.0 |
| Example 3 | 200 | 1.3 | 1.3 | 1.3 | 1.2 |
| Example 4 | 190 | 1.3 | 1.2 | 1.2 | 1.1 |
| Example 5 | 230 | 1.2 | 1.2 | 1.1 | 1.1 |
| Example 6 | 200 | 1.3 | 1.2 | 1.1 | 1.1 |

* B: Etching rate regarding the outside of the grooves A/B: Etching rate regarding the inside of the grooves/etching rate regarding the outside of the

Table 1-2: Evaluation of etching interface

| | 80nm | 100nm | 200nm | 400nm |
|---|---|---|---|---|
| Example 1 | Smooth | Smooth | Smooth | Smooth |
| Example 2 | Smooth | Smooth | Smooth | Smooth |
| Comp. Ex. 1 | Voided | Voided | Smooth | Smooth |
| Comp. Ex. | Voided | Voided | Smooth | Smooth |
| Example 3 | Smooth | Smooth | Smooth | Smooth |
| Example 4 | Smooth | Smooth | Smooth | Smooth |
| Example 5 | Smooth | Smooth | Smooth | Smooth |
| Example 6 | Smooth | Smooth | Smooth | Smooth |

**Claims**

1.  A process for producing a siliceous film, comprising:

    an insulating film forming step of forming an insulating film having a hydrogen content of not less than $9 \times 10^{20}$ atms/cm$^3$ as measured by a secondary ion mass spectrometry on a surface of a silicon substrate having concavoconvexes;
    a coating step of coating a composition containing a polysilazane compound on the substrate; and
    a curing step of heating the coated substrate to convert the polysilazane compound to a silicon dioxide film.

2.  The process according to claim 1, wherein the insulating film is a silicon dioxide film formed by plasma chemical vapor deposition using tetraethoxysilane.

3.  The process according to claim 1, wherein the insulating film is a silicon nitride film formed by plasma chemical vapor deposition.

4.  The process according to any one of claims 1 to 3, wherein the heating treatment is carried out in an inert gas or oxygen atmosphere having a water vapor concentration of not less than 1%.

5.  The process according to any one of claims 1 to 4, wherein the heating temperature in the heating treatment is 400 C or above and 1200 C or below.

**6.** The process according to any one of claims 1 to 5, wherein the thickness of the insulating film is 1 to 100 nm.

**7.** A method for forming a trench isolation structure, comprising providing a silicon substrate with concavoconvexes as a substrate with grooves for trench isolation structure formation, and the grooves are embedded by the process according to any one of claims 1 to 6.

**8.** The method according to claim 7, where the substrate with grooves for trench isolation is provided by

a) forming a silicon dioxide film on a surface of a silicon substrate, said silicon dioxide film having a thickness of 5 to 30 nm,
b) optionally forming a silicon nitride film having a thickness of 100 to 400 nm on said silicon dioxide film,
c) coating a photoresist on the film of step a) or b),
d) optionally drying or curing the photoresist film,
e) exposing and developing the photoresist film to form a pattern,
f) etching the silicon dioxide film of step a) and - if present - the silicon nitride film of step b) using the photoresist film as a mask, thus forming a pattern in the silicon dioxide film and - if present - in the silicon nitride film, and
g) dry etching the silicon substrate by using the patterned silicon dioxide film and - if present - silicon nitride film as a mask to form a trench isolation structure.

**Patentansprüche**

**1.** Verfahren zur Herstellung eines Siliziumoxid-haltigen Films, umfassend:

einen Schritt zur Ausbildung eines Isolierfilms des Ausbildens eines Isolierfilms mit einem Wasserstoffgehalt von nicht weniger als $9 \times 10^{20}$ atms/cm$^3$, gemessen durch sekundäre Ionenmassenspektrometrie auf einer Oberfläche eines konkav-konvexen Siliziumsubstrats;
einen Beschichtungsschritt des Auftragens einer Zusammensetzung, enthaltend eine Polysilazan-Verbindung, auf das Substrat; und
einen Härtungsschritt des Erhitzens des beschichteten Substrats, um die Polysilazan-Verbindung in einen Siliziumdioxidfilm umzuwandeln.

**2.** Verfahren gemäß Anspruch 1, wobei der Isolierfilm ein Siliziumdioxidfilm ist, gebildet durch chemische Plasmagasphasenabscheidung unter Verwendung von Tetraethoxysilan.

**3.** Verfahren gemäß Anspruch 1, wobei der Isolierfilm ein Siliziumnitridfilm ist, gebildet durch chemische Plasmagasphasenabscheidung.

**4.** Verfahren gemäß einem der Ansprüche 1 bis 3, wobei die Wärmebehandlung in einer Inertgas- oder Sauerstoffatmosphäre mit einer Wasserdampfkonzentration von nicht weniger als 1% durchgeführt wird.

**5.** Verfahren gemäß einem der Ansprüche 1 bis 4, wobei die Heiztemperatur in der Wärmebehandlung 400 C oder höher und 1200 C oder weniger beträgt.

**6.** Verfahren gemäß einem der Ansprüche 1 bis 5, wobei die Dicke des Isolierfilms 1 bis 100 nm beträgt.

**7.** Verfahren zur Bildung einer Rinnenisolationsstruktur, umfassend das Bereitstellen eines konkav-konvexen Siliziumsubstrats als Substrat mit Rillen für die Bildung der Rinnenisolationsstruktur, und die Rillen werden eingebettet durch das Verfahren gemäß einem der Ansprüche 1 bis 6.

**8.** Verfahren gemäß Anspruch 7, wobei das Substrat mit Rillen für die Rinnenisolation bereitgestellt wird durch

a) Ausbilden eines Siliziumdioxidfilms auf einer Oberfläche eines Siliziumsubstrats, wobei der Siliziumdioxidfilm eine Dicke von 5 bis 30 nm hat,
b) gegebenenfalls Ausbilden eines Siliziumnitridfilms mit einer Dicke von 100 bis 400 nm auf dem Siliziumdioxidfilm,
c) Auftragen eines Photoresists auf den Film aus Schritt a) oder b),
d) gegebenenfalls Trocknen oder Härten des Photoresistfilms,

e) Belichten und Entwickeln des Photoresistfilms, um ein Muster auszubilden,
f) Ätzen des Siliziumdioxidfilms aus Schritt a) und - falls vorhanden - des Siliziumnitridfilms aus Schritt b) unter Verwendung des Photoresistfilms als Maske, wodurch ein Muster in dem Siliziumdioxidfilm ausgebildet wird und - falls vorhanden - in dem Siliziumnitridfilm, und
g) Trockenätzen des Siliziumsubstrats durch Verwendung des gemusterten Siliziumdioxidfilms und - falls vorhanden - Siliziumnitridfilms als Maske, um eine Rinnenisolationsstruktur zu bilden.

**Revendications**

1. Procédé de production d'un film siliceux, comprenant :

   une étape de formation d'un film isolant consistant à former un film isolant ayant une teneur en hydrogène supérieure ou égale à $9 \times 10^{20}$ atomes/cm$^3$ telle que mesurée par spectrométrie de masse d'ions secondaires sur une surface d'un substrat de silicium ayant des formes concavo-convexes ;
   une étape de revêtement consistant à déposer une composition contenant un composé de polysilazane sur le substrat ; et
   une étape de durcissement consistant à chauffer le substrat revêtu pour transformer le composé de polysilazane en un film de dioxyde de silicium.

2. Procédé selon la revendication 1, dans lequel le film isolant est un film de dioxyde de silicium formé par dépôt chimique en phase vapeur assisté par plasma en utilisant du tétraéthoxysilane.

3. Procédé selon la revendication 1, dans lequel le film isolant est un film de nitrure de silicium formé par dépôt chimique en phase vapeur assisté par plasma.

4. Procédé selon l'une quelconque des revendications 1 à 3, dans lequel le traitement de chauffage est réalisé dans une atmosphère de gaz inerte ou d'oxygène ayant une concentration en vapeur d'eau supérieure ou égale à 1 %.

5. Procédé selon l'une quelconque des revendications 1 à 4, dans lequel la température de chauffage dans le traitement de chauffage est supérieure ou égale à 400 °C et inférieure ou égale à 1200 °C.

6. Procédé selon l'une quelconque des revendications 1 à 5, dans lequel l'épaisseur du film isolant est de 1 à 100 nm.

7. Procédé de formation d'une structure d'isolation par tranchées, comprenant l'obtention d'un substrat de silicium avec formes concavo-convexes en tant que substrat avec sillons pour formation d'une structure d'isolation par tranchées, les sillons étant enrobés par le procédé selon l'une quelconque des revendications 1 à 6.

8. Procédé selon revendication 7, dans lequel le substrat avec sillons pour isolation par tranchées est obtenu

   a) en formant un film de dioxyde de silicium sur une surface d'un substrat de silicium, ledit film de dioxyde de silicium ayant une épaisseur de 5 à 30 nm,
   b) éventuellement en formant un film de nitrure de silicium ayant une épaisseur de 100 à 400 nm sur ledit film de dioxyde de silicium,
   c) en déposant une résine photosensible sur le film de l'étape a) ou b),
   d) éventuellement en séchant ou en durcissant le film de résine photosensible,
   e) en exposant et en développant le film de résine photosensible pour former un motif,
   f) en gravant le film de dioxyde de silicium de l'étape a) et - s'il est présent - le film de nitrure de silicium de l'étape b) en utilisant le film de résine photosensible comme un masque, pour former ainsi un motif dans le film de dioxyde de silicium et - s'il est présent - le film de nitrure de silicium, et
   g) en gravant à sec le substrat de silicium en utilisant le film de dioxyde de silicium et - s'il est présent - le film de nitrure de silicium à motif comme un masque pour former une structure d'isolation par tranchées.

[Fig. 1]

[Fig. 2]

[Fig. 3]

{Fig. 4]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 3178412 A
- JP 2001308090 A
- JP 2002088156 A
- US 5614271 A, SHIBUYA TATSUHIKO [JP]